# EUROPÄISCHE PATENTSCHRIFT

(11) **EP 0 433 482 B1**
(45) Veröffentlichungstag und Bekanntmachung des Hinweises auf die Patenterteilung: **03.11.1993**
(21) Anmeldenummer: 89123568.1
(22) Anmeldetag: 20.12.1989
(51) Int. Cl.: G01R 33/035

(54) **SQUID-Sensoreinrichtung mit induktiver Einkopplung eines Eingangssignals in ein SQUID**
Squid sensor apparatus with inductive coupling of an input signal into a squid
Système de capteur squid avec couplage inductif entre le signal d'entrée et le squid

(43) Veröffentlichungstag der Anmeldung: 26.06.1991
(73) Patentinhaber: SIEMENS AKTIENGESELLSCHAFT, 80333 München (DE)
(72) Erfinder: Daalmans, Gabriel, D-8520 Erlangen (DE); Seifert, Heinrich, Dr., D-8526 Bubenreuth (DE)

(56) Entgegenhaltungen:
- EP-A- 0 279 291
- WO-A-81/03710
- IEEE TRANSACTIONS ON MAGNETICS. vol. 19, no. 3, Mai 1983, NEW YORK US Seiten 303 - 307; B.MUHLFELDER et al.: "Double Transformer Coupling to a Very Low Noise SQUID"

## Beschreibung

Die Erfindung bezieht sich auf eine SQUID-Sensoreinrichtung gemäß dem gattungsbildenden Teil (Oberbegriff) von Anspruch 1. Eine derartige Sensoreinrichtung ist der EP-A-0 279 291 zu entnehmen.

Mit supraleitenden Quanten-Interferometern, die auch als "SQUIDs" (Abkürzung von: Superconducting QUantum Interference Devices") bezeichnet werden, sind insbesondere sehr schwache magnetische Felder zu messen (vgl. z.B. die Veröffentlichung "IEEE Trans. Electron Dev.", Vol. ED-27, No. 10, Okt. 1980, Seiten 1896 bis 1908 ). Als bevorzugtes Anwendungsgebiet für SQUIDs wird deshalb die medizinische Technik angesehen, da die Magnetfelder des Herzes oder des Gehirns (Magnetokardiographie bzw. Magnetoenzephalographie) Feldstärken im pT-Bereich hervorrufen.

Eine entsprechende Meßvorrichtung enthält zumindest eine als Gradiometer oder Magnetometer gestaltete Antenne, eine Einkoppelspule, einen SQUID-Kreis mit in ihn integriertem SQUID, eine Modulationsspule, Verstärker und eine Auswerteelektronik. Bis auf die Verstärker und die Auswerteelektronik sind die genannten Teile dabei in einem Kryosystem untergebracht, um in ihnen supraleitende Betriebsbedingungen zu ermöglichen. Die Antenne weist mindestens eine Detektionsspule zur Erfassung des zu messenden Magnetfeldes auf. Das entsprechende Eingangssignal wird dann mit Hilfe der an dem SQUID angeordneten Einkoppelspule in das SQUID induktiv transformiert. Die Antenne und die Einkoppelspule bilden dabei einen geschlossenen supraleitenden Stromkreis bzw. Eingangskreis, der als ein Flußtransformator anzusehen ist. Zur Messung des in den SQUID-Kreis eingekoppelten Flusses oder von Flußgradienten werden sowohl RF-SQUIDs (Hochfrequenz- bzw. Radio-Frequency-SQUIDs) als auch DC-SQUIDs (Gleichstrom- bzw. Direct-Current-SQUIDs) eingesetzt.

Ein DC-SQUID besteht dabei normalerweise aus einer supraleitenden Schleife, die von zwei Josephson-Elementen unterbrochen ist. Zwischen diesen Josephson-Elementen sind zwei Gleichstromanschlüsse vorgesehen. Die Spannung zwischen diesen Anschlüssen müßte abhängig von einem eingekoppelten Magnetfluß variieren, falls dieser nicht mittels einer besonderen Rückkoppelspule, mit der ein entgegengesetztes Magnetfeld erzeugt wird, weitgehend konstant gehalten würde (flux-locked-loop). Aus dem Strom, der für die Rückkoppelspule benötigt wird, läßt sich dann auf die Größe des äußeren Magnetfeldes schließen. Dabei kann mittels einer Modulationsspule ein hochfrequentes Feld dem zu messenden Feld überlagert werden. Ein nachgeschalteter Verstärker verstärkt nur Signale, die der Frequenz und der Phasenlage des Hochfrequenzfeldes entsprechen (Lock-in-Technik).

Bei entsprechenden SQUID-Sensoreinrichtungen befindet sich im allgemeinen das SQUID zusammen mit der Einkoppelspule auf einem Trägerelement, das zusammen mit den auf ihm aufgebrachten Leiterteilen auch als Chip bezeichnet wird. Die somit ein Teil dieses Chips bildende Einkoppelspule muß deshalb an die externen, nicht auf dem Trägerelement befindlichen und zumeist vergleichsweise wesentlich größer (gröber) dimensionierten Teile des Eingangskreises kontaktiert werden. Entsprechende supraleitende Bonds (Kontaktverbindungen) sind jedoch im allgemeinen nur unter Verwendung einer Bleilegierung möglich.

Mit einer derartigen Kontaktierung sind jedoch eine Reihe von Problemen verbunden. So sind der Aufbau und der Wechsel der SQUID-Chips aufwendig. Auch können Ausfälle wegen defekter Bondverbindungen auftreten. Bei Niob-Dünnfilm-SQUIDs ist zur Anbringung supraleitender Bonds eine Übergangsmetallisierung erforderlich. Supraleitende Bleibonds sind außerdem mechanisch und chemisch, insbesondere wegen auftretender Korrosion, wenig stabil.

Die erwähnten Bondungsprobleme treten auch bei der aus der eingangs genannten EP-A-0 279 291 zu entnehmenden SQUID-Sensoreinrichtung auf. Diese Einrichtung enthält einen Eingangskreis mit einer Detektions- oder Sensorschleife zum Empfang des zu messenden Magnetfeldes. Das entsprechende Eingangssignal wird an einer Ausgangswicklung auf die Eingangswicklung eines Transformatorkreises übertragen. Der Transformatorkreis ist seinerseits induktiv an ein SQUID gekoppelt. Dieses SQUID kann sich zusammen mit dem Transformatorkreis auf einem gemeinsamen Trägerelement befinden. Die Ausgangswicklung des Eingangskreises und die Eingangswicklung des Transformatorkreises sind bei dieser Einrichtung so ausgebildet, daß ihre Gegeninduktivität mittels eines supraleitenden Schwingspiegels durch entsprechende Änderung der effektiven Größe eines Koppelloches mit einer Frequenz zu modulieren ist, die in einem für einen rauscharmen Betrieb des SQUIDs charakteristischen Frequenzbereich liegt. Auf diese Weise können magnetische Felder extrem niedriger Frequenz gemessen werden.

Aus der Veröffentlichung "IEEE Trans. Magn." Vol. MAG-19, No. 3, Mai 1983, Seiten 303 bis 307 ist ferner eine SQUID-Sensoreinrichtung mit einem Eingangskreis und einem Transformatorkreis, jedoch ohne Gegeninduktionsmodulation, bekannt. Auch hier treten die erwähnten Kontaktierungsprobleme auf, da sich sowohl die Ausgangswicklung des Eingangskreises sowie der Transformatorkreis und das SQUID auf einem gemeinsamen Trägerelement befinden.

Aufgabe der vorliegenden Erfindung ist es deshalb, eine SQUID-Sensoreinrichtung mit den eingangs genannten Gestaltungsmerkmalen dahingehend auszubilden, daß die genannten Kontaktierungsprobleme praktisch nicht gegeben sind.

Diese Aufgabe wird erfindungsgemäß mit den im kennzeichnenden Teil des Anspruchs 1 angegebenen Maßnahmen gelöst.

Bei der erfindungsgemäßen SQUID-Sensoreinrichtung erfolgt somit eine induktive Ein- und Auskopplung der Signale zum bzw. vom SQUID-Kreis. D.h., auf dem Trägerelement werden keine Teile des Eingangskreises direkt, insbesondere durch bekannte Dünnfilm-Techniken, abgeschieden. Der Eingangskreis ist also unabhängig von dem SQUID-Kreis und dem Transformatorkreis zu erstellen. Die mit dieser Ausgestaltung der SQUID-Sensoreinrichtung verbundenen Vorteile sind insbesondere darin zu sehen, daß spezielle Bondverbindungen zur Kontaktierung der Einkoppelspule an nicht auf dem Trägerelement befindliche Teile des Eingangskreises überflüssig sind. Damit können die genannten Kontaktierungsprobleme nicht mehr auftreten. Wegen der nunmehr fehlenden galvanischen Kopplung der Einkoppelspule an den Eingangskreis können außerdem Störsignale nicht unmittelbar zum SQUID gelangen und dessen Funktion beeinträchtigen bzw. das SQUID gegebenenfalls sogar zerstören. Da ferner der SQUID-Kreis auch nur induktiv mit der ihm nachgeordneten Elektronik verbunden ist, lassen sich auch hier supraleitende Bondverbindungen zu dem Trägerelement vermeiden. Der SQUID-Chip kann deshalb vorteilhaft als ein komplettes eigenes Bauteil vorgefertigt werden, das im Falle eines Defektes ohne Schwierigkeit austauschbar ist.

Vorteilhafte Ausgestaltungen der erfindungsgemäßen SQUID-Sensoreinrichtung gehen aus den abhängigen Ansprüchen hervor.

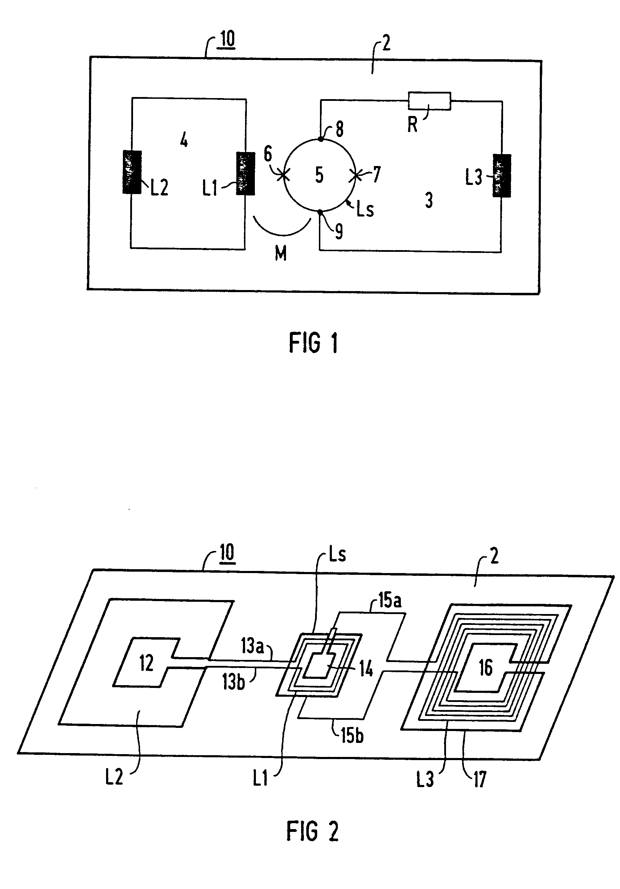

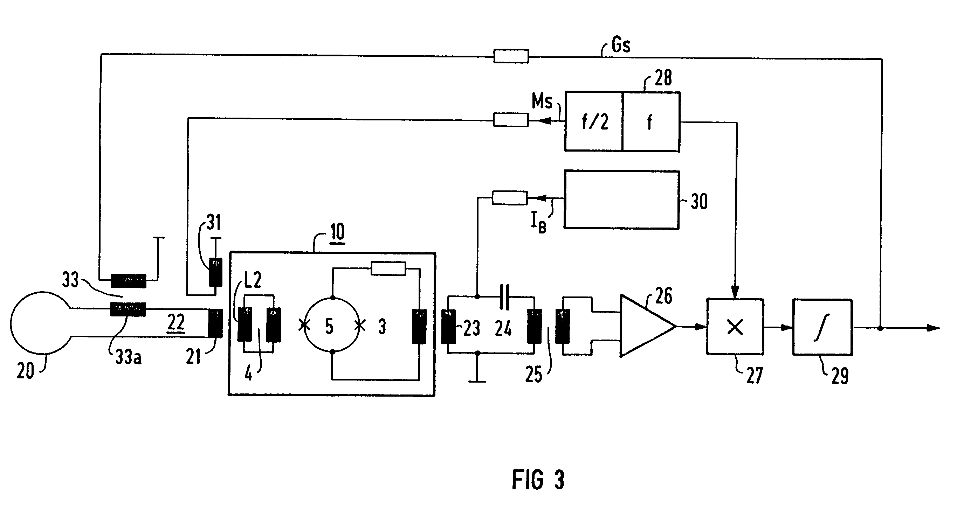

Zur weiteren Erläuterung der Erfindung wird nachfolgend auf die Zeichnung Bezug genommen, in deren Figur 1 eine prinzipielle Schaltung eines SQUID-Chips einer erfindungsgemäßen Sensoreinrichtung dargestellt ist. Figur 2 zeigt schematisch eine Schrägansicht auf eine konkrete Ausführungsform der in Figur 1 dargestellten Schaltungsteile. In Figur 3 sind wesentliche Teile einer Magnetometerschaltung mit einer erfindungsgemäßen Sensoreinrichtung wiedergegeben. In den Figuren sind sich entsprechende Teile mit denselben Bezugszeichen versehen.

Figur 1 zeigt einen Teil einer Schaltung für eine SQUID-Sensoreinrichtung nach der Erfindung. Bei den dargestellten Schaltungsteilen wird von für derartige Sensoreinrichtungen an sich bekannten supraleitenden Teilen ausgegangen. Diese Teile befinden sich auf einem besonderen plattenförmigen Trägerelement 2, das beispielsweise aus Si besteht. Die Schaltungsteile bilden einen SQUID-Kreis 3 sowie einen Transformatorkreis 4. Dabei wird unter einem "besonderen" Trägerelement allgemein ein Substratkörper verstanden, auf dem zumindest der SQUID-Kreis 3 und der Transformatorkreis 4, nicht aber Teile eines in der Schaltung aufgeführten Eingangskreises ausgebildet sind. D.h., gegebenenfalls können sich auf dem Trägerelement 2 noch andere Teile der Sensoreinrichtung befinden. Gemäß dem angenommenen Ausführungsbeispiel sollen jedoch die Kreise 3 und 4 allein auf dem Trägerelement 2 erstellt sein, also ein "eigenes" Trägerelement besitzen.

Der SQUID-Kreis 3 enthält ein gewöhnlich als DC-SQUID bezeichnetes SQUID 5. Dieses SQUID umfaßt eine SQUID-Schleife Ls mit mindestens einer Unterbrechung, an der zwei Josephson-Tunnelelemente (Josephson-Kontakte) 6 und 7 ausgebildet sind. Jedes Josephson-Element ist dabei normalerweise von einem in der der Figur nicht dargestellten Shuntwiderstand überbrückt (vgl. die genannte Veröffentlichung "IEEE Trans.El.Dev."). Zwischen den Josephson-Elementen weist die SQUID-Schleife Ls Anschlüsse 8 und 9 auf, an denen eine Auskoppelspule L3 angeschlossen ist. Dem SQUID kann außerdem eine Lastimpedanz zugeordnet sein, die einen ohmschen Widerstand R aufweist, der dem dynamischen Widerstand des SQUIDs angepaßt ist und in Reihe mit der Auskoppelspule L3 liegt.

Um in das SQUID 5 bzw. dessen SQUID-Schleife Ls einen magnetischen Fluß einzukoppeln, ist der SQUID-Schleife eine Einkoppelspule L1 zugeordnet. Die zwischen SQUID-Schleife und Einkoppelspule ausgebildete Gegeninduktivität ist mit M bezeichnet. Die Einkoppelspule L1 soll nicht, wie bei dem genannten Stand der Technik üblich, galvanisch mit in der Figur nicht dargestellten Teilen eines Eingangskreises, insbesondere eines Gradiometers, verbunden sein. Vielmehr ist gemäß der Erfindung eine induktive Ankopplung des Eingangskreises an das SQUID 5 über den Transformatorkreis 4 vorgesehen. Hierzu enthält der Transformatorkreis neben der Einkoppelspule L1 noch eine dem Eingangskreis zugewandte Eingangswicklung L2. Über diese Wicklung wird in den Transformatorkreis induktiv ein über den Eingangskreis geführtes bzw. mit diesem Kreis erzeugtes Eingangssignal wie z.B. ein magnetischer Fluß eingekoppelt. Durch die Wahl entsprechender Windungszahlen kann dabei die Induktivität der SQUID-Schleife Ls angepaßt werden.

Wie aus der Figur 1 ferner ersichtlich ist, kann auch das in dem SQUID-Kreis 5 erzeugte Signal induktiv über die Auskoppelspule L3 in eine nachgeordnete, signalverarbeitende Auswerteelektronik übertragen werden. Sieht man außerdem eine induktive Einkopplung eines zum Betrieb des SQUID-Kreises erforderlichen Bias-Stromes beispielsweise über die Auskoppelspule L3 vor, so ergibt sich der wesentliche Vorteil, daß keinerlei galvanische Kontakte zu den auf dem Trägerelement 2 befindlichen supraleitenden Teilen erforderlich sind. Diese supraleitenden Teile bilden mit dem besonderen Trägerelement 2 so vorteilhaft ein unabhängig von den übrigen Teilen der erfindungsgemäßen SQUID-Sensoreinrichtung herstellbares, als SQUID-Chip 10 bezeichnetes Bauteil. Ein konkretes Ausführungsbeispiel eines derartigen SQUID-Chips ist in Figur 2 schematisch als Schrägansicht veranschaulicht.

Die supraleitenden Teile des Chips 10 sind vorteilhaft in Dünnfilm-Technik auf der Oberfläche des Trägerelementes 2 abgeschieden. Sie werden u.a. von der Eingangswicklung L2 des Transformatorkreises 4 gebildet, die im wesentlichen aus einer breiten, ringförmigen Windung besteht, welche ein z.B. etwa quadratisches oder rechteckiges Koppelloch 12 umschließt. Die Windung ist auf einer Seite geschlitzt und geht dort in zwei Leiter 13a und 13b über. Diese Leiter stellen die Verbindung der Eingangswicklung L2 mit der Einkoppelspule L1 dar. Diese Einkoppelspule ist in bekannter Weise auf der ebenfalls geschlitzten, z.B. ein etwa quadratisches oder rechteckiges Koppelloch 14 umschließenden SQUID-Schleife Ls aufgebracht. Am Schlitz dieser SQUID-Schleife sind die ein DC-SQUID charakterisierenden beiden Josephson-Tunnelelemente ausgebildet (vgl. z.B. "IEEE Trans. Magn.", Vol. MAG-17, No. 1, Jan. 1981, Seiten 400 bis 403 oder die EP-A-0 246 419). Über zwei Verbindungsleiter 15a und 15b ist das so gebildete SQUID 5 an die Auskoppelspule L3 angeschlossen, wobei in mindestens einem der Verbindungsleiter der Lastwiderstand R integriert sein kann. Neben der Auskopplung des Spannungssignals am SQUID 5 kann vorteilhaft über die Spule L3 auch ein zum Betrieb des SQUIDs erforderlicher Bias-Strom erzeugt werden. Um dabei Verluste zu begrenzen, sollte die Impedanz dieser Spule bei einer vorgegebenen Betriebsfrequenz, die typisch 100 kHz sein kann, deutlich größer sein als der Widerstand des SQUIDs, der beispielsweise 5 Ω beträgt. Da die Einhaltung dieser Bedingung zu einer verhältnismäßig großen Windungszahl der Spule L3 führt, ist gemäß dem dargestellten Ausführungsbeispiel zu einer effektiven Einkopplung in diese Spule eine supraleitende Fläche zur Flußführung vorgesehen. Dementsprechend befindet sich die Auskoppelspule L3 auf einer ebenfalls einseitig geschlitzten, z.B. ein etwa quadratisches Koppelloch 16 umschließenden Flußführungsschleife 17. Während die Eingangswicklung L2, die SQUID-Schleife Ls sowie diese Flußführungsschleife 17 im allgemeinen jeweils nur aus einer einzigen Windung einer verhältnismäßig breiten Leiterbahn bestehen, werden die Einkoppelspule L1 durch einige und die Auskoppelspule L3 somit durch verhältnismäßig viele Windungen einer sehr schmalen Leiterbahn gebildet. Gemäß einem konkreten Ausführungsbeispiel des Chips 10 können folgende Größen für die einzelnen Spulen bzw. Schleifen vorgesehen werden:

**Tabelle**

| Spule/Schleife | Windungszahl | Induktivität | Ausdehnung (Seitenlänge) des zugeordneten Koppelloches |
|---|---|---|---|
| Ls | 1 | 100 pH | Koppelloch 14: 50 µm |
| L1 | 7 | 5 nH | siehe Ls |
| L2 | 1 | 4,7 nH | Koppelloch 12: 3 mm |
| L3 | 100 | 47 µH | Koppelloch 16: 3 mm |

An die auf dem Trägerelement 2 befindliche Eingangswicklung L2 sowie an die Auskoppelspule L3 des vorgefertigten SQUID-Chips 10 sind dann eine Ausgangswicklung eines Eingangskreises bzw. eine Eingangswicklung einer nachgeordneten Elektronik nachträglich anzufügen. Diese in der Figur nicht dargestellten Wicklungen des Eingangskreises bzw. der Elektronik werden also erfindungsgemäß nicht unmittelbar auf dem Trägerelement 2 erstellt.

Durch Betrieb des SQUID-Kreises der erfindungsgemäßen SQUID-Sensoreinrichtung nach einem der bekannten Wechselstrom-Bias-Verfahren ist es auch für DC-SQUIDs möglich, alle Funktionen induktiv an das SQUID zu koppeln. Entsprechende Verfahren sind auch unter dem Namen "DYNABIAS" (vgl. z.B. US-PS 4 389 612 ) oder "SHAD" (vgl. z.B. "Appl.Phys.Lett.", Vol. 49, No. 20, Nov. 1986, Seiten 1393 bis 1395) bekannt. Da dann die Ströme im SQUID 5, die für die Ein- und Auskopplung relevant sind, die beiden Josephson-Tunnelelemente des SQUIDs einmal seriell (zur Flußeinkopplung) und einmal parallel (zu einer Bias-Einkopplung und gleichzeitigen Signalauskopplung) ansprechen, sind dazu mindestens die beiden Koppelspulen L1 und L3 erforderlich.

Eine Anwendung einer entsprechenden SQUID-Sensoreinrichtung in einem Magnetometer, die nach dem "SHAD"-Verfahren betrieben wird, geht aus dem in Figur 3 angedeuteten Schaltbild hervor. Das Magnetometer ist einkanalig angenommen. Vielkanalige Ausführungen haben eine entsprechende Anzahl von SQUID-Sensoreinrichtungen. Bei der dem Schaltbild der Figur zugrundegelegten Ausführungsform wird ein mittels einer bekannten Magnetometerschleifenanordnung 20 detektiertes Eingangssignal über eine Ausgangswicklung 21 induktiv in den Transformatorkreis 4 des Chips 10 und von dort induktiv in das SQUID des SQUID-Kreises 3 eingekoppelt. Der mit der Schleifenanordnung 20 und der Wicklung 21 einen Flußtransformator bildende Kreis ist als Eingangskreis 22 bezeichnet. Das in dem SQUID-Kreis 3 erzeugte SQUID-Signal wird dann induktiv auf die Eingangswicklung 23 eines nachgeordneten Flußtransformators 24 übertragen und gelangt von dort über einen Signal-Resonanztransformator 25 in einen auf Raumtemperatur befindlichen Vorverstärker 26. Diesem Vorverstärker ist eine Mischerschaltung 27 nachgeordnet. In diese Mischerschaltung ist auch ein von einer Oszillatoreinrichtung 28 erzeugtes Signal eingespeist. Das so erhaltene Mischsignal wird dann über eine Integratorschaltung 29 an eine nachgeschaltete Elektronik zur weiteren Auswertung und Darstellung geleitet. Wie ferner aus dem gezeigten Schaltbild ersichtlich ist, wird von einer speziellen Bias-Oszilaltorschaltung 30 ein Bias-Wechselstrom I_{B} in den dem SQUID-Kreis 3 nachgeordneten Flußtransformator 24 eingespeist. Dieser Wechselstrom gelangt induktiv über das aus der Auskopppelspule des SQUID-Kreises 3 und der Eingangswicklung 23 des Flußtransformators 24 gebildete Koppelglied in den SQUID-Kreis. Die Oszillatoreinrichtung 28 erzeugt außerdem ein in den Transformatorkreis 4 über eine Modulationsspule 31 induktiv einzukoppelndes Modulationssignal Ms. Diese Modulationsspule bildet zusammen mit der Eingangswicklung L2 des Transformatorkreises 4 einen Koppeltransformator. Darüber hinaus kann vorteilhaft durch eine Gegenkopplung bis zum Eingangskreis 22 die Gesamtschaltung linearisiert werden. Ein entsprechendes Gegenkopplungssignal Gs wird beispielsweise am Ausgang der Integratorschaltung 29 abgenommen und zu einem Gegenkopplungstransformator 33 geführt, dessen eine Wicklung 33a in den Eingangskreis 22 integriert ist.

Gemäß dem in Figur 3 dargestellten Ausführungsbeispiel wurde eine Anwendung der SQUID-Sensoreinrichtung nach der Erfindung in einem Magnetometer angedeutet. Der Einsatz der Sensoreinrichtung ist jedoch auf diesen Anwendungsfall nicht beschränkt. Vielmehr kann die erfindungsgemäße SQUID-Sensoreinrichtung vorteilhaft überall dort eingesetzt werden, wo bei Dünnfilm-SQUID-Chips die erwähnten Kontaktierungsprobleme auftreten.

Für die erfindungsgemäße SQUID-Sensoreinrichtung können deren supraleitenden Teile aus den bekannten klassischen Supraleitermaterialien hergestellt sein, die mittels einer LHe-Technik auf ihrer supraleitenden Betriebstemperatur von z.B. 4,2 K gehalten werden. Ein besonderer Vorteil der induktiven Kopplung bei der erfindungsgemäßen Sensoreinrichtung ist jedoch bei einer Verwendung bekannter Hoch-T_{c}-Supraleitermaterialien zu sehen, die im allgemeinen mit einer LN₂-Technik z.B. auf einer Temperatur von 77 K zu halten sind. Bei diesen metalloxidischen Hoch-T_{c}-Supraleitermaterialien wie z.B. auf Basis des Stoffsystems Y-Ba-Cu-O, Bi-Sr-Ca-Cu-O oder Tl-Ba-Ca-Cu-O sind nämlich supraleitende Bondverbindungen aufgrund der ausgeprägten Anisotropie des oxidkeramischen Materials nur äußerst schwierig auszubilden. Selbst normalleitende Verbindungen mit diesen Supraleitermaterialien bereiten große Probleme.

## Patentansprüche

1. SQUID-Sensoreinrichtung mit
- einem zwei Josephson-Elemente (6, 7) aufweisenden SQUID (5), das Teil eines SQUID-Kreises (3) ist,
- einem Eingangskreis (22) zum Empfang von magnetischen Feldsignalen und zur Übertragung entsprechender Eingangssignale,
- einem Transformatorkreis (4), der über eine Eingangswicklung (L2) induktiv an eine Ausgangswicklung (21) des Eingangskreises (22) und zur Einkopplung der Eingangssignale in das SQUID (5) über eine Einkoppelspule (L1) induktiv an dieses gekoppelt ist,
und
- einer dem SQUID-Kreis (3) nachgeordneten Elektronik (24 bis 29) zur Auswertung von in dem SQUID-Kreis (3) in Abhängigkeit von den Eingangssignalen hervorgerufenen Ausgangssignalen,
**dadurch gekennzeichnet,** daß
a) der SQUID-Kreis (3) eine Auskoppelspule (L3) für eine induktive Auskopplung der Ausgangssignale in eine Eingangswicklung (23) der nachgeordneten Elektronik (24 bis 29) enthält und zusammen mit dem Transformatorkreis (4) vorgefertigt auf einem besonderen Trägerelement (2) angeordnet ist
sowie
b) die nicht auf dem Trägerelement (2) ausgebildete Ausgangswicklung (21) des Eingangskreises (22) und die Eingangswicklung (L2) des Transformatorkreises (4) ebenso nachträglich aneinandergefügt sind wie die nicht auf dem Trägerelement (2) ausgebildete Eingangswicklung (23) der nachgeordneten Elektronik (24 bis 29) und die Auskoppelspule (L3) des SQUID-Kreises (3).

2. Sensoreinrichtung nach Anspruch 1 , **dadurch gekennzeichnet**, daß für eine Modulation des SQUIDs (5) eine Modulationsspule (31) vorgesehen ist, mittels derer ein Modulationssignal induktiv in den Transformatorkreis (4) einzukoppeln ist.

3. Sensoreinrichtung nach Anspruch 1 oder 2, **dadurch gekennzeichnet,** daß für einen Betrieb des SQUIDs (5) nach einem Wechselstrom-Bias-Verfahren eine induktive Einkopplung des Bias-Signals in den SQUID-Kreis (3) über dessen Auskoppelspule (L3) vorgesehen ist.

4. Sensoreinrichtung nach einem der Ansprüche 1 bis 3, **dadurch gekennzeichnet,** daß eine Gegenkopplung eines Ausgangssignals der nachgeordneten Elektronik (24 bis 29) induktiv in den Eingangskreis (22) vorgesehen ist.

5. Sensoreinrichtung nach einem der Ansprüche 1 bis 4, **dadurch gekennzeichnet,** daß die Auskoppelspule (L3) auf einer supraleitenden Schleife (17) zur Flußführung angeordnet ist.

6. Sensoreinrichtung nach einem der Ansprüche 1 bis 5, **dadurch gekennzeichnet,** daß zumindest die auf dem Trägerelement (2) befindlichen supraleitenden Teile des Transformatorkreises (4) und des SQUID-Kreises (3) aus einem metalloxidischen Hoch-T_{c}-Supraleitermaterial mit einer Sprungtemperatur über 77 K bestehen.

## Claims

1. SQUID-sensor device having
- a SQUID (5) which has two Josephson-elements (6, 7) and which is part of a SQUID-circuit (3),
- an input circuit (22) for receiving magnetic field signals and for transmitting corresponding input signals,
- a transformer circuit (4) which is coupled by way of an input winding (L2) inductively to an output winding (21) of the input circuit (22) and for the purpose of coupling the input signals into the SQUID (5) by way of an input coupling coil (L1) inductively to said SQUID (5),
and
- an electronics unit (24 to 29) which is arranged after the SQUID-circuit (3) for the evaluation of output signals which are produced in the SQUID-circuit (3) as a function of the input signals,
characterised in that
a) the SQUID-circuit (3) contains an output coupling coil (L3) for inductively coupling out the output signals into an input winding (23) of the subsequently arranged electronics unit (24 to 29) and is arranged on a special carrier element (2) together with the transformer circuit (4) in a pre-fabricated manner and also
b) the output winding (21) of the input circuit (22), which winding (21) is not formed on the carrier element (2), and the input winding (L2) of the transformer circuit (4) are joined together subsequently in the same way as the input winding (23) of the subsequently arranged electronics unit (24 to 29), which winding (23) is not formed on the carrier element (2), and the output coupling coil (L3) of the SQUID-circuit (3).

2. Sensor device according to claim 1, characterised in that a modulation coil (31) is provided for modulation of the SQUID (5), by means of which coil (31) a modulation signal can be coupled inductively into the transformer circuit (4).

3. Sensor device according to claim 1 or 2, characterised in that for operation of the SQUID (5) according to an alternating current bias method it is provided that the bias signal is inductively coupled into the SQUID-circuit (3) by way of the latter's output coupling coil (L3).

4. Sensor device according to one of the claims 1 to 3, characterised in that it is provided that an output signal of the subsequently arranged electronics unit (24 to 29) is inductively counter-coupled into the input circuit (22).

5. Sensor device according to one of the claims 1 to 4, characterised in that the output coupling coil (L3) is arranged on a superconducting loop (17) for flux guidance.

6. Sensor device according to one of the claims 1 to 5, characterised in that at least the superconducting parts of the transformer circuit (4) and of the SQUID-circuit (3), which parts are located on the carrier element (2), consist of a metal-oxidic high-T_{c}-superconductor material with a transition temperature of over 77 K.

## Revendications

1. Dispositif de détection SQUID comportant
- un dispositif SQUID (5) comportant deux éléments de Josephson (6,7) et qui fait partie d'un circuit SQUID (3),
- un circuit d'entrée (22) servant à recevoir des signaux de champ magnétiques et à transmettre des signaux d'entrée correspondants,
- un circuit transformateur (4), qui est couplé de façon inductive, par l'intermédiaire d'un enroulement d'entrée (L2), à un enroulement de sortie (21) du circuit d'entrée (22) et qui est couplé de façon inductive, pour le couplage des signaux d'entrée dans le dispositif SQUID (5), par l'intermédiaire d'une bobine de couplage (L1), à ce dispositif SQUID, et
- un système électronique (24 à 29) branché en aval du circuit SQUID (3), servant à évaluer des signaux de sortie produits dans le circuit SQUID (3) en fonction des signaux d'entrée,
caractérisé par le fait que
a) le circuit SQUID (3) comporte une bobine de découplage (L3) pour réaliser un découplage inductif des signaux de sortie et pour envoyer ces derniers dans un enroulement d'entrée (23) du système électronique (24 à 29) branché en aval, et il est disposé, en étant préfabriquée conjointement avec le circuit transformateur (4), sur un élément de support particulier (2), et
b) l'enroulement de sortie (21), qui n'est pas formé sur l'élément de support (2), du circuit d'entrée (22) et l'enroulement d'entrée (L2) du circuit transformateur (4), qui sont également assemblés postérieurement, comme l'enroulement d'entrée (23), qui n'est pas formé sur l'élément de support (2), du système électronique (24 à 29) branché en aval et la bobine de découplage (L3) du circuit SQUID (3).

2. Dispositif de détection suivant la revendication 1, caractérisé par le fait que pour une modulation du dispositif SQUID (5), il est prévu une bobine de modulation (31), au moyen de laquelle un signal de modulation doit être injecté de façon inductive dans le circuit transformateur (4).

3. Dispositif de détection suivant la revendication 1 ou 2, caractérisé par le fait que pour un fonctionnement du dispositif SQUID (5) selon un procédé de polarisation à courant alternatif, il est prévu une injection inductive du signal de polarisation dans le circuit SQUID (3), par l'intermédiaire de sa bobine de découplage (L3).

4. Dispositif de détection suivant l'une des revendications 1 à 3, caractérisé par le fait qu'il est prévu une injection inductive, par contre-réaction, dans le circuit d'entrée (22), d'un signal de sortie du système électronique (24 à 29) branché en aval.

5. Dispositif de détection suivant l'une des revendications 1 à 4, caractérisé par le fait que la bobine de découplage (L3) est disposée dans une boucle supraconductrice (17) pour le guidage du flux.

6. Dispositif de détection suivant l'une des revendications 1 à 5, caractérisé par le fait qu'au moins les parties supraconductrices, qui sont situées sur l'élément de support (2), du circuit transformateur (4) et du circuit SQUID (3), sont constituées par un matériau supraconducteur à température T_{c} élevée, formé d'un oxyde métallique, et possédant une température de changement brusque supérieure à 77 K.
